# EUROPEAN PATENT SPECIFICATION

(11) **EP 3 486 950 B1**
(45) Date of publication and mention of the grant of the patent: **27.05.2020**
(21) Application number: 17201950.7
(22) Date of filing: 15.11.2017
(51) Int. Cl.: H01L 29/06, H01L 29/423, H01L 29/786, H01L 29/66, H01L 21/306

(54) **METHOD FOR FABRICATING A HORIZONTAL GATE-ALL-AROUND FIELD EFFECT TRANSISTOR**
VERFAHREN ZUR HERSTELLUNG EINES GATE-ALL-AROUND FELDEFFEKTTRANSISTORS
PROCÉDÉ DE FABRICATION D'UN TRANSISTOR À EFFET DE CHAMP À TYPE GAA

(43) Date of publication of application: 22.05.2019
(73) Proprietor: IMEC vzw, 3001 Leuven (BE); Katholieke Universiteit Leuven, 3000 Leuven (BE)
(72) Inventor: Loo, Mr. Roger, 3001 Leuven (BE); Porret, Mr. Clement, 3001 Leuven (BE); Vohra, Mr. Anurag, 3001 Leuven (BE)
(74) Representative: Patent Department IMEC

(56) References cited:
- EP-A1- 2 819 154
- CN-A- 106 158 633
- US-A1- 2013 017 660
- US-A1- 2013 183 814
- US-A1- 2013 256 838
- US-B1- 8 691 640
- YUAN DONG ET AL: "Chlorine- and Fluorine-based dry etching of Germanium-Tin", 2014 7TH INTERNATIONAL SILICON-GERMANIUM TECHNOLOGY AND DEVICE MEETING (ISTDM), IEEE, 2 June 2014 (2014-06-02), pages 99-100, XP032635987, DOI: 10.1109/ISTDM.2014.6874686 ISBN: 978-1-4799-5427-8 [retrieved on 2014-08-08]
- D. L. FLAMM: "Mechanisms of silicon etching in fluorine- and chlorine-containing plasmas", PURE & APPLIED CHEMISTRY, vol. 62, no. 9, 1 January 1990 (1990-01-01), pages 1709-1720, XP055475193, GB ISSN: 0033-4545, DOI: 10.1351/pac199062091709
- SUYOG GUPTA ET AL: "Highly Selective Dry Etching of Germanium over Germanium-Tin (Ge 1- x Sn x ): A Novel Route for Ge 1- x Sn x Nanostructure Fabrication", NANO LETTERS, vol. 13, no. 8, 14 August 2013 (2013-08-14), pages 3783-3790, XP055475143, ISSN: 1530-6984, DOI: 10.1021/nl4017286

## Description

### Technical Field of the Invention

The present invention is related to the field of semiconductor manufacturing. More specifically, it is related to a method for selective etching.

### Background of the invention

Selective etching is one of the commonly used process steps in semiconductor device manufacturing for various purposes. It results in obtaining desired surfaces or structures, which may then further be followed by other process steps, such as for example, a subsequent deposition process or a further etching process to enable pattern transfer. Obtaining the necessary etch selectivity is of key importance, in the absence of which geometry loss of other features can occur, which is undesirable. Geometry loss can lead to integration issues, deterioration of the device performance and increase of manufacturing cost due to yield reduction.

As the semiconductor industry is trying to keep up with scalability, new device architectures are being explored to provide the required device performance. Depending on the type of device architecture, new integration challenges are being faced during the manufacturing. The selective etching, on the other hand, still remains to be one of the main integration challenges of new device architectures.

A gate-all-around (GAA) field effect transistor (FET), for example, comprising lateral or horizontal nanowires (NWs), has been proposed to improve gate control for sub-5nm technology.

The current process flow for making horizontal NWs starts with the deposition of a multi-stack consisting of a sacrificial layer and a layer of a channel material. After fin patterning, dummy gate formation and source-drain (S/D) replacement, the sacrificial layers are selectively removed with respect to the layers of the channel material leaving horizontal NWs. In case of limited selectivity of the etch process with respect to the channel layers, channel layers could also be etched away partially. This can have adverse effects on the device performance.

Therefore, there is still a need in the art for methods to selectively etch layers in semiconductor manufacturing, particularly to selectively etch layers comprising providing improved channel mobility.

### Summary of the invention

It is an object of the present invention to provide a simple method for selective etching a first feature comprising a Sn-containing first Group IV material with respect to a second feature comprising a second Group IV material.

It is an object of the present invention to provide a method for selective etching a first feature comprising a Sn-containing first Group IV material with respect to a second feature comprising a second Group IV material having a controlled and uniform etch rate.

It is an object of the present invention to provide a method for reducing the variation in the dimensions of the second feature, comprising a second Group IV material, in comparison to the dimensions intended in the design, while a first feature comprising a Sn-containing first Group IV material is being etched selectively.

The above objectives are accomplished by a method according to the present invention as defined in claim 1.

In a **first aspect,** the present invention relates to a method for fabricating a horizontal gate-all-around field effect transistor comprising removing a first feature comprising a Sn-containing first Group IV material selectively to a second feature comprising a second Group IV material. The method comprises providing, in a process chamber, a substrate having an upper surface, wherein the first feature and the second feature are arranged on the upper surface. The Sn-containing first Group IV material comprises a dopant element. The substrate is heated in the process chamber. An etch process is performed comprising introducing, into the process chamber, an etching gas and subjecting the substrate to the etching gas, wherein the etching gas is a chlorine-based or a bromine-based gas.

The inventors have found that the method according to embodiments of the present invention enables selective etching of a first feature with respect to a second feature, during semiconductor manufacturing, where the first feature comprises a Sn-containing Group IV material and the second feature comprises a second Group IV material, when a chlorine-based or a bromine-based gas is used as the etching gas. The fact that the Sn-containing Group IV material comprises a dopant element permits improved selectivity in etching of the first feature with respect to the second feature using the chlorine-based or the bromine-based gas as the etching gas.

European patent application EP 2 819 154 A1 relates to a method for forming a strained semiconductor structure, the structure being strained in order to improve the performance of the structure; however, does not address the manufacturing of gate-all-around (GAA) field effect transistor (FET).

On the other hand, Yuan Dong et.al., 2014, 7th International Silicon-Germanium. Technology and Device Meeting, IEEE, 2 June 2014*,* report results on Cl- and F- based dry etching of Ge₁₋ₓSnₓ. Etch rate selectivity of Ge₁₋ₓSnₓ over Ge under different etching conditions were studied. It is reported that high selectivity can be achieved by F-based dry etching due to the formation of non-volatile etching products at Ge₁₋ₓSnₓ surface.

Furthermore, CN 106 158 633 A, provides a formation method of a nanowire field effect transistor. The formation method comprises the steps that a substrate is provided, a stack structure formed by germanium layers and germanium tin layers through alternate stacking is formed on the substrate, and the stack structure comprises a nanowire region and a source electrode region and a drain electrode region which are respectively arranged at the two sides of the nanowire region; a patterned mask layer is formed on the stack structure, and a part of surface of the nanowire region of the stack structure is exposed out of the patterned mask layer; the dry etching process is performed, and a part of the top germanium tin layer of the nanowire region is removed through etching so that top nanowires are formed; the microwave etching process is performed, a layer of the germanium layer of the bottom part of the top nanowires is removed through etching so that a groove is formed and the top nanowires are enabled to be suspended; and the anisotropic first etching process and the isotropic second etching process are cyclically performed, and the lower germanium tin layers and the germanium layers are etched in turn so that the corresponding lower nanowires are formed and the grooves enabling the corresponding lower nanowires to be suspended are formed.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement on selective etching of such materials in this field, the present concepts are believed to represent substantially new and novel improvements, including departures from prior practices, resulting in the provision of more efficient selective etching processes.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the figures

**Fig. 1** Etch selectivity of Ge_{1-y}Sn_{y} with respect to Ge as a function of etch temperature during etching.
**Fig. 2a** and **Fig. 2b** show schematically the substrate and the arranged first feature and the second feature.
**Fig. 3a** and **Fig. 3b** show schematically the substrate and the first feature and the second feature arranged in the form of a multi-layer stack.
**Fig. 4** shows schematically a first multi-layer stack in a first region and a second multi-layer stack in a second region.

### Detailed description of the invention

The present invention will be described with respect to embodiments and regarding certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term *"comprising",* used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.

Reference throughout the specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of the description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

As used herein and unless provided otherwise, the term *"**relaxed Si₁₋ₓGeₓ***" or *"**relaxed Ge***" refers to Si₁₋ₓGeₓ or Ge relieved of any stress, i.e. having their lattice parameter corresponding to that of the corresponding bulk material.

As used herein and unless provided otherwise, the term *"**horizontal gate-all-around field effect transistor (GAA-FET)**"* is a transistor where the gate surrounds the channel region of horizontal nanowires or horizontal nano-sheets on all sides.

As used herein and unless provided otherwise, the term ***"dimensions intended in the design",*** refer to the dimensions of the features for which they are designed.

As used herein and unless provided otherwise, a GAA-FET, refers to a device in which the channel is comprised in one or more nanowires.

As used herein and unless provided otherwise, a GAA-FET, where the multi-layer stack is a stack of nano-sheets, is a nano-sheet-based GAA-FET in which channel is comprised in the nano-sheets.

As used herein and unless provided otherwise, *"**a monolayer**"* is defined as a single layer of atoms that covers a surface on which it is provided.

The method starts with providing a substrate (10) in a process chamber. In embodiments, the substrate may be a bulk semiconductor substrate. In alternative embodiments, the substrate may comprise one or more layers such as in the case of a Silicon-On-Insulator (SOI) substrate, Germanium-On-Insulator (GeOI) substrate, Silicon-Germanium-On-Insulator (SiGeOI) substrate. In embodiments, the process chamber may be a process chamber of a tool, whereby an etch process can be carried out. The substrate (10) has an upper surface (15). In embodiments, the upper surface (15) of the substrate (10) may be a flat surface without protrusions or it may possess topography. In preferred embodiments, the upper surface may be a flat surface having an Root Mean Square (RMS) roughness value of less than 1nm as measured by Atomic Force Microscopy (AFM). A first feature comprising a Sn-containing first Group IV material (30) and a second feature (20) comprising a second Group IV material are arranged on the upper surface (15) and the Sn-containing first Group IV material comprises a dopant element. The substrate (10) is heated in the process chamber. An etch process is performed comprising introducing, into the process chamber, an etching gas. The substrate is subjected to the etching gas. The etching gas is a chlorine-based or a bromine-based gas. Subjecting the substrate, including the first feature (30) and the second feature (20), to the chlorine-based gas or to the bromine based gas removes the first feature (30) selective to the second feature (20).

In embodiments, the second Group IV material is free of Sn.

The invention enables selective etching of the first feature with respect to the second feature when the etching gas is the chlorine-based or the bromine-based gas and when the Sn-containing first Group IV material (30) comprises the dopant element.

The inventors have found out that the first feature (30) comprising the Sn-containing first Group IV material has a higher etch rate than the second feature (20) comprising the second Group IV material when the substrate, including the first feature (30) and the second feature (20), is subjected to the chlorine-based or the bromine-based gas. The etch selectivity can further be improved by enabling a controlled and uniform etching.

The inventors have thus found out that the dopant element comprised in the Sn-containing first Group IV material (30) provides improved etch selectivity of the first feature with respect to the second feature. In this context, improved etch selectivity refers to the increase in the ratio of the etching rates between first material and second material. In this way, preservation of the dimensions of the second feature during the etch process is achieved thanks to improved selectivity of the etch process.

It is advantageous that the chlorine-based or bromine-based etching gas is not detrimental for the gas supply lines and for the process chamber itself while also providing improved etch selectivity in combination with the presence of the dopant element comprised in the Sn-containing first Group IV material.

In embodiments, the chlorine-based or the bromine-based etching gas providing these advantages may, respectively, be Cl₂ or HCl and Br₂ or HBr.

The Sn-containing first Group IV material is Ge_{1-y}Sn_{y}, wherein 4 %<y<20 % atomic.

The second Group IV material is Ge. The advantage of using Ge_{1-y}Sn_{y}, wherein 4 % <y<20 % atomic, in combination with Ge is such that the selective etching enables obtaining Ge layers. However, outside of the scope of the present invention other Group IV material combinations may be used. Obtaining Ge layers is advantageous for the fabrication of GAA-FET devices having Ge as channel material. These materials are currently being considered in so-called high mobility materials GAA-FET devices. Typically, relaxed Ge is used for n-type GAA devices, while strained Ge is used for p-type GAA-FET devices. Preferably, the strained Ge used for p-type GAA-FET device is compressively strained.

The presence of Sn improves the etch selectivity. However, there exists a critical Sn content in terms of atomic percentage above which Sn precipitation or agglomeration occurs. This critical Sn content is determined not only by the process conditions of making the Ge_{1-y}Sn_{y} layer but also by how the layer stack is made. Furthermore, the critical Sn content depends on the thickness of the Ge_{1-y}Sn_{y} layer. It makes it also possible to grow multi-layers as long as the layer thickness is kept under a critical thickness value.

In preferred embodiments, atomic percentage denoted by "y" for Sn may be 6<y<10.

In embodiments, the dopant element may be incorporated into the Sn-containing first Group IV material during the growth of the first feature. Thus, the Sn-containing first Group IV material may be in-situ doped. Growth of Sn-containing first Group IV material may be done by epitaxy. Incorporation of the dopant element may also be done by solid state doping. While doping may also be done, after growth, by using ion implantation, it may not be as advantageous as the in-situ doping. This is because the depth of implantation of the dopant element may change and be difficult to control as a function of the dopant element since some dopant elements have higher diffusion coefficients than others. Besides, the implantation process itself may damage the material. The annealing process, which is typically carried out after the implantation process in order to cure the damages made, may be disadvantageous since it can affect material properties in several ways. Furthermore, the annealing process might lead to the diffusion of Group IV elements, thus causing a reduction in the steepness of the concentration gradient from one layer to the other if the first feature and the second feature are made in the form of nanowires or nano-sheets. In that case, it becomes difficult to main the etch selectivity. This annealing process is typically done at temperature above 500 °C, which would be at risk for leading to precipitation of the Sn. On the other hand, in-situ doping during the growth does not damage the lattice as long as the doping concentration remains below 1E21 cm⁻³. Furthermore, it provides better control of the distribution of the doping element within the material, which will then be advantageous in terms of providing uniform etching and thus, better etch selectivity. Additionally, in-situ doping during epitaxial growth allows to deposit multilayers with sharp transitions in composition and in doping concentration and with a repetition of doped/un-doped layers. This is not possible with one implantation step. Furthermore, application of ion implantation will have impact on process throughput since it usually is performed in a separate tool.

In embodiments, the dopant element may be an n-type dopant element. The n-type doping element may be phosphorus, arsenic, antimony, or bismuth. In embodiments, a doping concentration of the n-type dopant element may be in the range of 1E19 to 1E21 cm⁻³.

In alternative embodiments, the dopant element may be a p-type dopant element such as boron, aluminum, gallium, or indium. In preferred embodiments, the p-type dopant element may be boron or gallium.

In embodiments, the etch process may be a dry etch process or a vapor etch process.

In embodiments, the etch process is a vapor etching process and the chlorine-based or bromine-based etching gas is provided into the process chamber in the presence of a carrier gas. Vapor etching is advantageous since it provides improved etch selectivity compared to the other etching alternatives and permits the selective etching process to become independent of the arrangement of the first feature and the second feature on the substrate. Furthermore, , uniform etching will occur from all sides that are accessible to the etching gas.

Vapor etching can be performed by providing a liquid etchant and bubbling an inert gas, such as N₂, through the liquid etchant such that the etchant is obtained in gas phase and this gas phase etchant is used for carrying out the etching. However, in this typical vapor etching process, the liquid etchant is in the form of an aqueous solution and therefore, moisture may be carried away with the etchant being in gas phase when a carrier gas, which is an inert gas, is bubbled through the liquid etchant. Avoiding moisture incorporation or reducing its concentration in the bubbled gas is not straightforward and requires further process parameter adjustments, thus, making the etching process become more cumbersome. Therefore, during the vapor etching of the present invention, the chlorine-based or the bromine-based etching gas is provided into the process chamber in the presence of a carrier gas and it is thus not provided by bubbling the carrier gas through the liquid etchant.

In embodiments, the carrier gas may be H₂, N₂, He or Argon. It is advantageous to use H₂ as the carrier gas since it helps to slow down the etch rate and to better control the etch reaction.

Typically, a process chamber has a stage, on which the substrate is placed. The stage is capable of being heated through which the substrate will also be heated, if necessary.

In embodiments, the substrate may be heated up to a temperature below 500 °C inside the process chamber. Thus, provision of the substrate into the process chamber may be done at room temperature. Heating the substrate (10) may be provided by heating the process chamber. The temperature of the process chamber may be measured by thermocouples present inside the stage on which the substrate is positioned inside the process chamber. Thus, assuming absence of a temperature gradient or a negligible temperature gradient across the thickness of the substrate, the substrate temperature corresponds to this temperature measured by the thermocouples.

In alternative embodiments, the temperature up to which the substrate is heated may be measured by pyrometers. In such a case, it is possible to measure the surface temperature of the substrate. The etch process is performed by introducing, into the process chamber, the etching gas upon reaching a required temperature as a result of the heating.

In alternative embodiments, the process chamber may be heated up to a temperature below 500 °C, before the introduction of the substrate into the process chamber. In these alternative embodiments, this pre-heat temperature is lower than the temperature at which the etch process will be performed. Upon reaching the temperature as a result of this pre-heating, the substrate is introduced into the process chamber and positioned on the stage. Following it, the process chamber and thus, the substrate (10) is heated further up to a required temperature at which the etch process is to be performed. The etch process is then performed by introducing, into the process chamber, the etching gas upon reaching the required temperature as a result of the heating. Since etching rate changes as a function of temperature, it is advantageous to heat the substrate and allow for the substrate to reach a stabilized required temperature before the introduction of the etching gas. Introducing the etching gas into the process chamber after stabilizing the substrate temperature, thus, aids to control the etch rate during the removal of the first feature (30) selective to the second feature (20).

In embodiments, where the Sn-containing first Group IV material is Ge_{1-y}Sn_{y} and the second Group IV material is Ge, this temperature is below 500 °C. Heating above 500 °C, in these embodiments, would be disadvantageous since Sn present in the Sn-containing first Group IV material would start to precipitate. Sn precipitation adversely influences etching, thus leading to variation in etch selectivity, which is undesirable.

In embodiments, the process chamber may be the process chamber of a reactor. This reactor may be a hot or a cold wall reactor. This is advantageous since it avoids the risk of having gas condensation.

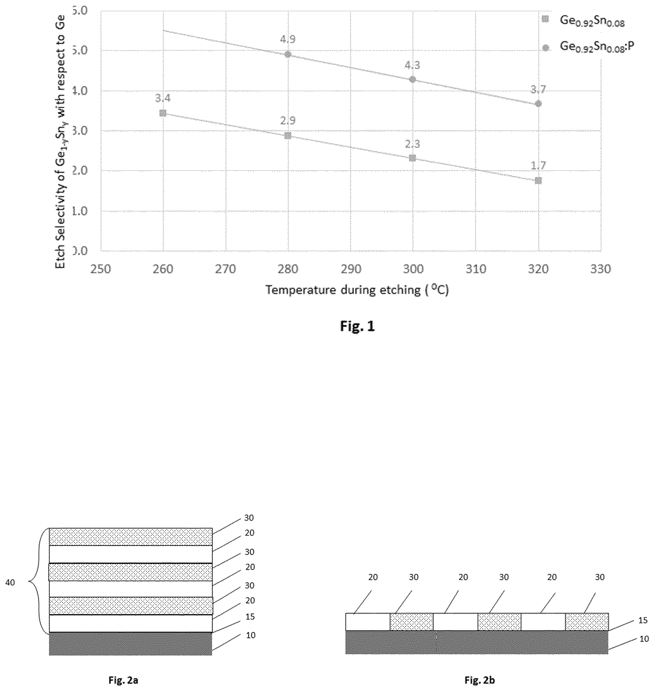

Figure 1 shows an example of etch selectivity obtained as a function of etch temperature, whereby Cl₂ is used as the etching gas. Etch selectivity is calculated to be the ratio of etch rate of Ge_{1-y}Sn_{y} with y = 8 % atomic, with respect to that of Ge. The inventors have observed that etch selectivity higher than 1 is obtained for Ge_{1-y}Sn_{y}, with y = 8 % atomic, with respect to Ge at etching temperatures particularly below 320°C. Also, it has been observed that Ge_{1-y}Sn_{y}, with y = 8 % atomic and having phosphorus doping of 1E20 cm⁻³ exhibits further enhanced etch selectivity compared to the case for Ge_{1-y}Sn_{y} with y = 8 % atomic without the phosphorus doping.

We now refer to **Fig. 2** illustrating schematically arrangement of the first feature (30) and the second feature (20) on the upper surface (15). Purely to facilitate understanding, different layers are shown with different numbers, however; this should not be construed in any limiting sense.

In embodiments, the first feature (30) and the second feature (20) may be arranged on the upper surface (15) by stacking alternately and repeatedly on one another forming a multi-layer stack (40) (**Fig. 2a**).

In these embodiments, the first feature (30) or the second feature (20) of the multi-layer stack (40) may be in contact with the upper surface (15) of the substrate (10).

Although the first feature and the second feature are arranged as such, the first feature (30) and the second feature (20), in these embodiments, may be connected to or supported by another feature by their surfaces at their extremities. It is via these extremities that the first feature (30) and the second feature (20) are attached to the substrate through this another feature comprising a material that is not etched during the selective etching. Thus, after completion of selective etching the second features (20) of the multi-layer stack (40) do not fall onto the upper surface (15) of the substrate (10). The first (30) and the second (20) features in these embodiments, may be in the form of nanowires or nano-sheets.

In alternative embodiments, the first feature (30) and the second feature (20) may be arranged on the upper surface (15) alternately and repeatedly in a horizontal direction along the upper surface (15) of the substrate (10). In these alternative embodiments, the first feature (30) and the second feature (20) may touch each other (**Fig. 2b**) or they may be separated from each other by a gap or by the presence of another feature (not shown in the figures). In these alternative embodiments, an upper surface of the first feature (30) and/or that of the second feature (20), may be abutting the upper surface (15) of the substrate (10) (not shown in the figures). Yet, in alternative embodiments, the first feature (30) and the second feature (20) may protrude from the upper surface (15) of the substrate (10), thereby having their upper surface extending away from the upper surface (15) of the substrate (10) (not shown in the figures).

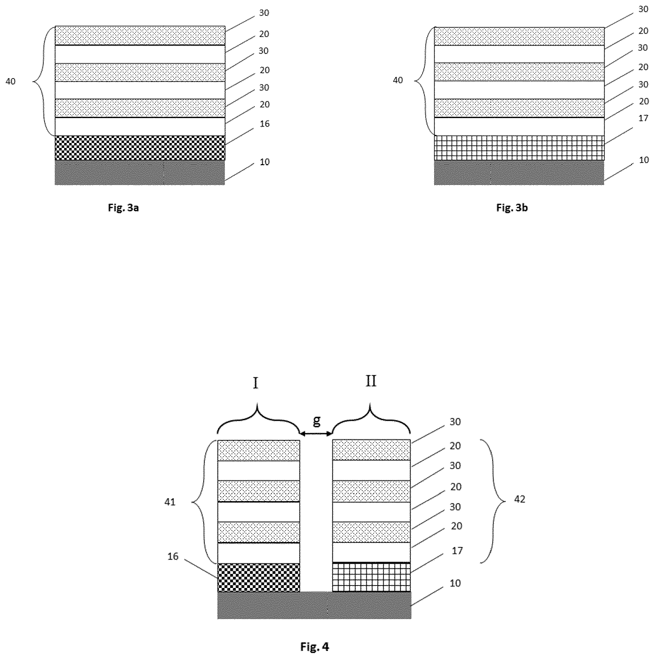

We now refer to **Fig. 3** illustrating schematically arrangement of the first feature (30) and the second feature (20) on the upper surface (15) being stacked alternately and repeatedly on one another forming a multi-layer stack (40).

In embodiments relating to **Fig. 3****,** the upper surface (15) of the substrate (10) may comprise relaxed Si₁₋ₓGeₓ or relaxed Ge, such as a relaxed Si₁₋ₓGeₓ layer (16) (**Fig. 3a**) or a relaxed Ge layer (17) (**Fig. 3b**). The upper surface (15) may, for example, be the upper surface of the relaxed Si₁₋ₓGeₓ layer (16) (**Fig. 3a**) or the relaxed Ge layer (17) (**Fig. 3b**) comprised in the substrate (10).

In alternative embodiments, the upper surface (15) of the substrate (10) may comprise the upper surface of the relaxed Si₁₋ₓGeₓ layer (16) or the relaxed Ge layer (17) (not shown in the figures).

In embodiments, where the substrate (10) comprises relaxed Ge, the first second feature (20) in contact with the upper surface (15) may be disregarded, thus the feature of the multi-layer stack (40) contacting with the upper surface (15) may be the first feature (30).

When the first feature (30) and the second feature (20) are stacked alternately and repeatedly on one another forming a multi-layer stack (40), the advantage of having relaxed Si₁₋ₓGeₓ (16) comprised in the upper surface (15) of the substrate (10) is such that all the features of the multi-layer stack (40) will be compressively strained. Thus, after removal of the first feature (30), compressively strained second features (20) will be obtained. While on the other hand, the advantage of having relaxed Ge (17) comprised in the upper surface of the substrate is such that no compressive strain will be present in the second feature (20).

In embodiments, x may be at least 50% atomic.

In preferred embodiments, x may be in the range 70% ≤ x ≤ 100 % atomic.

n embodiments, the method may further comprise, after performing the etch process, providing a conformal capping layer on the second feature. The provision of this conformal capping layer is advantageous since it protects the second feature (20) against surface contamination, surface damage or surface oxidation. In the case of surface contamination or surface oxidation, it leads to an increased throughput time or costs if it is not desired since the contaminants or the oxide layer have to be removed through further process steps.

In embodiments, the provision of the conformal capping layer may be done in-situ. That is to say, it may be done in-situ following the etch process. When the second feature is such that it is prone to surface contamination, surface damage or surface oxidation faster in ambient conditions when the substrate is taken out from the process chamber into ambient, this in-situ provision of the conformal capping layer ensures that surface contamination, surface damage or surface oxidation is prevented.

In embodiments, the capping layer may be a Si capping layer.
The Si capping layer may be grown at a temperature not higher than 700°C. In embodiments, where the second feature is a strained Ge, the Si capping layer is grown at a temperature not higher than 400° C. Si comprising precursors such as SiH₄, SiCl₂H₂, Si₂H₂, Si₃H₈, Si₄H₁₀, Si₅Hl₂, Si₂Cl₂H₄ or any other suitable Si comprising precursors may be used. The precursor may be supplied in the presence of a carrier gas such as H₂ or N₂. The pressure of the process chamber during the growth process may be kept at atmospheric pressure or lower.

In embodiments, the thickness of the Si capping layer may be in the range of 1 to 15 mono layers. In preferred embodiments, the thickness may be in the range of 2 to 7 monolayers. In embodiments, where the second feature is strained Ge, this is advantageous since the interface quality between the Si capping and strained Ge will be improved due to the reduction in the interface trap density.

In embodiments, the present invention relates to a method for fabricating a horizontal gate-all-around field effect transistor (GAA-FET). The method may comprise removing the first feature comprising a Sn-containing first Group IV material selective to a second feature comprising a second Group IV material according to any embodiments of the present invention, wherein the upper surface may comprises relaxed Si₁₋ₓGeₓ, wherein x is at least 50 5 atomic or relaxed Ge and wherein the first feature and the second feature may be arranged on the upper surface by stacking alternately and repeatedly on one another, thereby forming a multi-layer stack. In preferred embodiments, 70 %<x<100 % atomic.

In embodiments, the first feature (30) and the second feature (20) may be nanowires or nano-sheets. In these embodiments, the removal of the first feature (30) selective to the second feature (20) results in the definition of at least a horizontal nanowire or a horizontal nano-sheet comprising a channel region.

This is advantageous since suspended nanowires or nano-sheets of Group IV material (20) can be obtained after removal of the first feature (30) without affecting their geometry and their dimensions with respect to that before the removal of the first feature (30). This becomes even more advantageous when more than two nanowires or nano-sheets are to be manufactured since preserving the geometry of these nano-structures and obtaining a uniform geometry for all of them are important for the performance of the transistor.

Typically, the channel region in a horizontal GAA-FET is a region of the horizontal nanowire or the nano-sheet not comprising their lateral extremities. This is because the extremities are typically comprised in the source and the drain region of the semiconductor structure. Thus, the first feature (30) and the second feature (20) may, in embodiments, at their lateral extremities, be connected to or supported by the source/drain contacts of the horizontal GAA-FET. Therefore, after the removal of the first feature (30) selective to the second feature (20), the second feature of the multi-layer stack (40) can free stand without collapsing onto the substrate (10).

For the manufacturing of horizontal GAA-FETs where a Group IV material, such as for example Ge, will become the channel layer, a multi-layer stack of Si₁₋ₓGeₓ/Ge may be used. Following the deposition of a multi-layer stack made up of Si₁₋ₓGeₓ layers, acting as the sacrificial layers, and Ge layers, acting as the channel layer, fin patterning, dummy gate formation and source/drain (S/D) replacement is done. It is then followed by the selective removal of the sacrificial layer of the multi-layer stack. The selective removal of Si₁₋ₓGeₓ is typically done by wet etching. However, wet etching of Si₁₋ₓGeₓ has several drawbacks such as severe Ge loss due to limited etch selectivity. Furthermore, raised Source/Drain epitaxial growth cannot be used since selective etch will widen the gate in between the nanowires or nano-sheets.

Although replacing the Si₁₋ₓGeₓ in the multi-layer stack by a Sn-containing Group IV material, such as Ge_{1-y}Sn_{y}, wherein 4 %<y<20 % atomic, preferably 6 %<y<10 % atomic, and performing the selective removal by a vapor etch process using a chlorine-based or a bromine-based gas according to embodiments of the present invention can help to solve some of these issues, the etch selectivity is still not ideal to obtain nanostructures having uniform dimensions, especially when the number of intended nanowires or nano-sheets would be more than two. The fact that the Sn-containing first Group IV material comprises a dopant element, thus helps to improve the etch selectivity of the first feature with respect to the second feature during the selective removal by the vapor etch process using the chlorine-based or the bromine-based gas. This further permits having uniform dimensions for the second feature after selective removal without jeopardizing the intended dimensions.

When the first feature (30) and the second feature (20) are stacked alternately and repeatedly on one another forming a multi-layer stack (40) and that the substrate comprising the relaxed Si₁₋ₓGeₓ is such that the complete upper surface (15) of the substrate (10) is the upper surface of the relaxed Si₁₋ₓGeₓ layer, the advantage is such that all the features of the multi-layer stack (40) will be compressively strained. Thus, after removal of the first feature (30), compressively strained second features (20) will be obtained. This is beneficial to manufacture a p-MOS device.

While on the other hand, when the first feature (30) and the second feature (20) are stacked alternately and repeatedly on one another forming a multi-layer stack (40) and that the substrate comprising the relaxed Ge is such that the complete upper surface (15) of the substrate (10) comprises a layer of relaxed Ge or the complete upper surface (15) of the substrate (10) is the upper surface of the relaxed Ge layer, the advantage is such that no compressive strain will be present in the multi-layer stack (40). Thus, after removal of the first feature (30), second features (20) with no compressive strain will be obtained. This is beneficial to manufacture a n-MOS device. It is also beneficial that such a substrate can be used to manufacture CMOS devices.

In embodiments, the upper surface (15) may comprise relaxed Si₍₁₋ₓ₎Geₓ (16) in a first region (I) and relaxed Ge (17) in a second region (II). The first region (I) may be located at a distance (g) from the second region (II). The multi-layer stack may be a first multi-layer stack (41) on the first region (I) and separated by a distance (g) from a second multi-layer stack (42) on the second region (II) and the horizontal GAA FET may be a complimentary horizontal GAA FET. The separation of the first region (I) from the second region (II) by the distance (g) provides to tune the strain state of nanowires or nano-sheets that will be obtained in the first region (I) and in the second region (II), after the selective removal, independent from each other.

The advantage is, therefore, such that a p-type horizontal GAA FET can be manufactured in the first region (I), while a n-type horizontal GAA FET can be manufactured in the second region (II) on same substrate. This further permits to reduce the manufacturing cost since all the processing is done on the same substrate and more importantly nanowires or nanosheets for two different types of devices, namely for the p-type and the n-type, can be obtained by performing one selective removal.

In embodiments, the distance (g) may have a width of at least 10 nm. The distance (g) can further be tuned according to the technology node being used to fabricate the horizontal gate-all-around field effect transistor.

In embodiments, the upper surface comprising relaxed Si₁₋ₓGeₓ, wherein x is at least 50 % atomic in the first region (I) may be the upper surface of the relaxed Si₁₋ₓGeₓ layer (**Fig. 4**) and the upper surface comprising relaxed Ge in the second region (II) may be the upper surface of the relaxed Ge layer (**Fig. 4**). Preferably, 70%<x100% atomic.

In alternative embodiments, the upper surface of the substrate (10) may comprise the upper surface of the relaxed Si₁₋ₓGeₓ layer in the first region (I) (not shown in the figures) and the upper surface of the relaxed Ge layer in the second region (II) (not shown in the figures). In these alternative embodiments, the first region (I) and the second region (II) may be separated from each other over the distance (g) by an insulation layer. Thus, the upper surface of the relaxed Si₁₋ₓGeₓ layer in the first region (I), the upper surface of the relaxed Ge layer in the second region (II) and the upper surface of the insulation layer in between the first region (I) and the second region (II) may abut a common planar surface (not shown in the figures).

In embodiments, the provision of the conformal Si capping on the second feature, which may be a horizontal nanowire or a horizontal nano-sheet of a horizontal GAA FET is advantageous since it helps to obtain an improved interface having lower interface trap density between the nanowire or the nano-sheet when a high-k dielectric layer is deposited; this high-k dielectric layer being a gate dielectric of the FET. Furthermore, the provision of the Si capping layer increases the Negative Bias Temperature Instability (NBTI), which is an indication of the transistor having improved reliability characteristics. NBTI exhibits itself as an increase in threshold voltage and consequently a decrease in drain current and transconductance of the FET. In embodiments, the provision of the conformal Si capping layer may be done in-situ following the etch process during the fabrication of the horizontal gate-all-around field effect transistor. This way, the risk of surface oxidation and/or surface damage of the nanowires or nano-sheets can be diminished in cases when the second feature is prone to surface oxidation or surface damage. These advantages are experienced when the Sn-containing first Group IV (sacrificial) material is Ge_{1-y}Sn_{y}, wherein 4<y<20, preferably 6<y<10, and where the second Group IV material is Ge. This is due to the fact that surface oxidation or damage of Ge is diminished. Furthermore, possible Ge material loss is avoided, which can result in the case when Ge is oxidized, which needs to be removed, thus, leading to aforementioned material loss.

In embodiments, the thickness of the conformal Si capping layer being the range of 1 to 15 monolayers or preferably in the range of 2 to 7 monolayers in advantageous for the horizontal GAA FET. This is because the contribution of the Si capping layer to the Equivalent Oxide Thickness (EOT) will be kept to a minimum. This is desirable since as feature sizes are shrinking and SiO₂ is being replaced by high-k dielectrics as the gate oxide of the FETs, semiconductor industry is also calling for a lowered EOT value.

In embodiments, the conformal Si capping layer provided in-situ on the horizontal nanowire or on the nano-sheet may further be oxidized. This is advantageous due to the fact that the oxide formed on the conformal Si capping layer acts an interface layer when a gate dielectric is deposited on it.

## Claims

1. Method for fabricating a horizontal gate-all-around field effect transistor, the method comprising:
providing, in a process chamber, a substrate (10) having an upper surface (15), wherein a first feature (30) comprising a Sn-containing first Group IV material and a second feature (20) comprising a second Group IV material are arranged on the upper surface (15) by stacking alternately and repeatedly on one another, thereby forming a multi-layer stack (40, 41, 42) and wherein the upper surface (15) comprises relaxed Si₁₋ₓGeₓ, wherein x is at least 50 % atomic or relaxed Ge, wherein the Sn-containing first Group IV material is Ge_{1-y}Sn_{y}, wherein 4 %<y<20 % atomic and comprises a dopant element, wherein the dopant is an n-type dopant or a p-type dopant and wherein the second Group IV material is Ge.
- heating, in the process chamber, the substrate (10), and thereafter;
- performing an etch process comprising:
a. introducing, into the process chamber, an etching gas,
b. subjecting the substrate (10) to the etching gas, wherein the etching gas is a chlorine-based or a bromine-based gas, thereby removing the first feature (30) selective to the second feature (20).

2. The method according to claim 1, wherein the dopant element is n-type.

3. The method according to claim 1 or 2, wherein the etch process is a vapor etching process and the chlorine-based or bromine-based etching gas is provided into the process chamber in the presence of a carrier gas.

4. The method according to any one of the preceding claims, wherein the substrate (10) is heated up to a temperature below 500 °C.

5. The method according to any one of the preceding claims, wherein the chlorine-based gas is Cl₂ or HCl.

6. The method according to any one of the preceding claims, wherein the bromine-based gas is Br₂ or HBr.

7. The method according to any one of the preceding claims, wherein the method further comprises, after performing the etch process, providing a conformal capping layer on the second feature (20).

8. The method according to claim 7, wherein providing the conformal capping layer is done in-situ.

9. The method according to claim 7 or 8, wherein the capping layer is a Si capping layer.

10. The method according to claim 1, wherein the upper surface (15) comprises, respectively, relaxed Si₁₋ₓGeₓ in a first region (I) and relaxed Ge in a second region (II), the first region (I) being located at a distance (g) from the second region (II) and wherein the multi-layer stack (40, 41, 42) is a first multi-layer stack (41) on the first region (I) separated by the distance (g) from a second multilayer stack (42) on the second region (II) and wherein the horizontal gate-all-around field effect transistor is complimentary horizontal gate-all-around field effect transistor.

11. The method according to any one of the preceding claims, wherein the first feature (30) and the second feature (20) are nanowires or nano-sheets.

## Patentansprüche

1. Verfahren zum Fertigen eines horizontalen Gate-All-Around-Feldeffekttransistors, wobei das Verfahren folgende Schritte umfasst:
Bereitstellen, in einer Prozesskammer, eines Substrats (10), das eine obere Oberfläche (15) aufweist, wobei ein erstes Merkmal (30), das ein Sn-haltiges erstes Material der Gruppe IV umfasst, und ein zweites Merkmal (20), das ein zweites Material der Gruppe IV umfasst, auf der oberen Oberfläche (15) durch abwechselndes und wiederholtes Stapeln aufeinander angeordnet werden, wodurch sie einen mehrlagigen Stapel (40, 41, 42) bilden, und wobei die obere Oberfläche (15) relaxiertes Si₁₋ₓGeₓ umfasst, wobei x mindestens zu 50 % atomares oder relaxiertes Ge ist, wobei das Snhaltige erste Material der Gruppe IV Ge_{1-y}Sn_{y} ist, wobei 4 % < y < 20 % atomar ist und ein Dotierungselement umfasst, wobei das Dotiermittel ein n-leitendes Dotiermittel oder ein p-leitendes Dotiermittel ist, und wobei das zweite Material der Gruppe IV Ge ist,
- Erhitzen des Substrats (10) in der Prozesskammer und anschließend
- Ausführen eines Ätzprozesses, der Folgendes umfasst:
a) Einführen eines Ätzgases in die Prozesskammer,
b) Aussetzen des Substrats (10) an das Ätzgas, wobei das Ätzgas ein chlor- oder brombasiertes Gas ist, wodurch das erste Merkmal (30) gegenüber dem zweiten Merkmal (20) selektiv entfernt wird.

2. Verfahren nach Anspruch 1, wobei das Dotierungselement n-leitend ist.

3. Verfahren nach Anspruch 1 oder 2, wobei der Ätzprozess ein Dampfphasen-Ätzprozess ist und das chlor- oder brombasierte Ätzgas in der Prozesskammer in Gegenwart eines Trägergases bereitgestellt wird.

4. Verfahren nach einem der vorhergehenden Ansprüche, wobei das Substrat (10) auf eine Temperatur von unter 500 °C erhitzt wird.

5. Verfahren nach einem der vorhergehenden Ansprüche, wobei das chlorbasierte Gas Cl₂ oder HCl ist.

6. Verfahren nach einem der vorhergehenden Ansprüche, wobei das brombasierte Gas Br₂ oder HBr ist.

7. Verfahren nach einem der vorhergehenden Ansprüche, wobei das Verfahren ferner nach dem Ausführen des Ätzprozesses das Bereitstellen einer konformen Deckschicht auf dem zweiten Merkmal (20) umfasst.

8. Verfahren nach Anspruch 7, wobei das Bereitstellen der konformen Deckschicht vor Ort erfolgt.

9. Verfahren nach Anspruch 7 oder 8, wobei die Deckschicht eine Si-Deckschicht ist.

10. Verfahren nach Anspruch 1, wobei die obere Oberfläche (15) jeweils relaxiertes Si₁₋ₓGeₓ in einer ersten Region (I) und relaxiertes Ge in einer zweiten Region (II) umfasst, wobei sich die erste Region (I) in einem Abstand (g) von der zweiten Region (II) befindet, und wobei der mehrlagige Stapel (40, 41, 42) ein erster mehrlagiger Stapel (41) auf der ersten Region (I) ist, der um den Abstand (g) von einem zweiten mehrlagigen Stapel (42) auf der zweiten Region (II) getrennt ist, und wobei der horizontale Gate-All-Around-Feldeffekttransistor ein komplementärer horizontaler Gate-All-Around-Feldeffekttransistor ist.

11. Verfahren nach einem der vorhergehenden Ansprüche, wobei das erste Merkmal (30) und das zweite Merkmal (20) Nanodrähte oder Nanosheets sind.

## Revendications

1. Procédé de fabrication d'un transistor à effet de champ à grille enrobante horizontale, le procédé comprenant :
la fourniture, dans une chambre de traitement, d'un substrat (10) présentant une surface supérieure (15), dans lequel une première caractéristique (30) comprenant un premier matériau du groupe IV contenant du Sn et une seconde caractéristique (20) comprenant un second matériau du groupe IV sont agencées sur la surface supérieure (15) en s'empilant de façon alternée et répétée l'une sur l'autre, formant ainsi un empilement multicouche (40, 41, 42) et dans lequel la surface supérieure (15) comprend du Si₁₋ₓGeₓ relaxé, dans lequel x représente au moins 50 % de Ge atomique ou relaxé, dans lequel le premier matériau du groupe IV contenant du Sn est Ge_{1-y}Sn_{y}, dans lequel 4 % < y < 20 % atomique et comprend un élément dopant, dans lequel le dopant est un dopant de type n ou un dopant de type p et dans lequel le second matériau du groupe IV est Ge.
- le chauffage, dans la chambre de traitement, du substrat (10), et ensuite
- la réalisation d'un traitement de gravure comprenant :
a) l'introduction, dans la chambre de traitement, d'un gaz de gravure,
b) l'exposition du substrat (10) au gaz de gravure, dans lequel le gaz de gravure est un gaz à base de chlore ou un gaz à base de brome, éliminant ainsi la première caractéristique (30) sélectivement par rapport à la seconde caractéristique (20).

2. Procédé selon la revendication 1, dans lequel l'élément dopant est du type n.

3. Procédé selon les revendications 1 ou 2, dans lequel le traitement de gravure est un traitement de gravure en phase vapeur et le gaz de gravure à base de chlore ou à base de brome est fourni dans la chambre de traitement en présence d'un gaz support.

4. Procédé selon l'une quelconque des revendications précédentes, dans lequel le substrat (10) est chauffé jusqu'à une température inférieure à 500 °C.

5. Procédé selon l'une quelconque des revendications précédentes, dans lequel le gaz à base de chlore est Cl₂ ou HCl.

6. Procédé selon l'une quelconque des revendications précédentes, dans lequel le gaz à base de brome est Br₂ ou HBr.

7. Procédé selon l'une quelconque des revendications précédentes, dans lequel le procédé comprend en outre, après réalisation du traitement de gravure, la fourniture d'une couche de revêtement conforme sur la seconde caractéristique (20).

8. Procédé selon la revendication 7, dans lequel la fourniture de la couche de revêtement conforme se fait in situ.

9. Procédé selon les revendications 7 ou 8, dans lequel la couche de revêtement est une couche de revêtement de Si.

10. Procédé selon la revendication 1, dans lequel la surface supérieure (15) comprend, respectivement, un Si₁₋ₓGeₓ relaxé dans une première région (I) et du Ge relaxé dans une seconde région (II), la première région (I) étant située à une distance (g) de la seconde région (II) et dans lequel l'empilement multicouche (40, 41, 42) est un premier empilement multicouche (41) sur la première région (I) séparé par la distance (g) d'un second empilement multicouche (42) sur la seconde région (II) et dans lequel le transistor à effet de champ à grille enrobante horizontale est un transistor à effet de champ à grille enrobante horizontale complémentaire.

11. Procédé selon l'une quelconque des revendications précédentes, dans lequel la première caractéristique (30) et la seconde caractéristique (20) sont des nanofils ou des nanofeuillets.
